# EUROPEAN PATENT APPLICATION

(11) **EP 4 734 710 A1**
(43) Date of publication of application: **29.04.2026**
(21) Application number: 25168207.6
(22) Date of filing: 03.04.2025
(51) Int. Cl.: H10F 30/225, H10F 77/14

(54) **SINGLE PHOTON AVALANCHE DIODE WITH STI STRUCTURES**

(30) Priority: 24.10.2024 US 202418925637
(71) Applicant: GLOBALFOUNDRIES Singapore Pte. Ltd., Singapore 738406 (SG)
(72) Inventor: Zheng, Ping, 738406 Singapore (SG); Gramuglia, Francesco, 81541 Munich (DE); Toh, Eng Huat, 738406 Singapore (SG); Hoentschel, Jan, 01109 Dresden (DE)
(74) Representative: Grünecker Patent- und Rechtsanwälte PartG mbB

(57) **Abstract**

A single photon avalanche diode (SPAD) device includes a semiconductor substrate (122), a central source/drain (114), an outer source/drain (112), and a shallow trench isolation (STI) structure (120) between the central source/drain and the outer source/drain at an incident surface (118) of the substrate, wherein a width of the STI structure is at least one third of a width of the central source/drain. The SPAD device may have superior dark current rate compared to conventional devices.

## Description

### BACKGROUND

Photodetectors are sensors that detect the presence of electromagnetic radiation. Semiconductor photodiodes are a category of photodetectors that use a P-N diode to convert incident photons into current. Photodiodes are used by many different technologies to sense one or more frequency of light, to determine the time at which transmitted light is reflected back to the photodiode, etc.

Avalanche photodiodes are a highly biased photodiodes in which photo-generated carriers are multiplied by avalanche breakdown in the device. Single photon avalanche diodes (SPADs) are avalanche photodiodes which are sensitive enough to detect the incidence of a single photon, and have lower noise and jitter than typical photodiodes.

One measure of SPAD performance is dark count rate (DCR), which is the average rate of registered counts in the absence of incident light. The DCR of an SPAD establishes the noise floor, and minimizing DCR can substantially improve SPAD performance.

### SUMMARY

Embodiments of the present application relate to an SPAD device, a photodetector, and a method for forming an SPAD device. The SPAD device includes a shallow trench isolation (STI) structure on an incident surface of the device.

According to at least some of the embodiments disclosed herein, a single photon avalanche diode (SPAD) device includes a semiconductor substrate, a central source/drain, an outer source/drain, and an STI structure between the central source/drain and the outer source/drain at an incident surface of the substrate. A width of the STI structure may be at least one third of a width of the central source/drain.

According to at least some of the embodiments disclosed herein, a photodetector includes a control circuit and at least one SPAD coupled to the control circuit. The at least one SPAD includes a semiconductor substrate, a central source/drain, an outer source/drain, and an STI structure between the central source/drain and the outer source/drain at an incident surface of the substrate. A width of the STI structure may be least one third of a width of the central source/drain.

According to at least some of the embodiments disclosed herein, a method for forming an SPAD device includes forming a shallow trench isolation (STI) structure in a semiconductor substrate, forming a central source/drain in and opening of the STI structure, and forming an outer source/drain around the STI structure. The STI structure is located between the central source/drain and the outer source/drain at an incident surface of the substrate, and a width of the STI structure may be at least one third of a width of the central source/drain.

### BRIEF DESCRIPTION OF THE DRAWINGS

FIG. 1 illustrates a photodetector according to an embodiment.
FIG. 2 illustrates an SPAD device according to an embodiment.
FIG. 3 illustrates a cross-sectional view of the SPAD of FIG. 2.
FIGS. 4A, 4B, 4C and 4D illustrate steps in an embodiment of a process for forming the SPAD device of FIG. 2.
FIG. 5 illustrates dimensions of structures of an SPAD device.

### DETAILED DESCRIPTION

Embodiments of the present disclosure relate to a single photon avalanche photodiode (SPAD) device, a photodetector including the SPAD device, and a method of forming the SPAD device.

A detailed description of embodiments is provided below along with accompanying figures. The scope of this disclosure is limited by the claims and encompasses numerous alternatives, modifications and equivalents. Although steps of various processes are presented in a given order, embodiments are not necessarily limited to being performed in the listed order. In some embodiments, certain operations may be performed simultaneously, in an order other than the described order, or not performed at all.

Numerous specific details are set forth in the following description. These details are provided to promote a thorough understanding of the scope of this disclosure by way of specific examples, and embodiments may be practiced according to the claims without some of these specific details. Accordingly, the specific embodiments of this disclosure are illustrative, and are not intended to be exclusive or limiting. For the purpose of clarity, technical material that is known in the technical fields related to this disclosure has not been described in detail so that the disclosure is not unnecessarily obscured. The figures are not drawn to scale, and features are enlarged or diminished for visual clarity.

Dark count rate (DCR) is a significant source of noise in SPAD devices. Previous efforts for reducing the DCR of SPAD devices have focused on the construction of the absorption region and thermal regulation. Forming additional structures at the incident surface of SPAD devices has been disparaged in the art because such structures could interfere with the detection of photons and were found to reduce sensitivity and efficacy of SPAD devices.

Previous investigations into replacing or supplementing virtual guard rings with isolation structures found that doing so increases the DCR (Ha, 2022) and can cause an SPAD to fail to show the avalanche response (Shin, 2019). Accordingly, it has been generally accepted in the art that isolation structures at an incident surface of an SPAD should be minimized or avoided altogether. However, the inventors of the present disclosure have discovered that providing a shallow trench isolation structure (STI) with a relatively large size relative to a source/drain region reduces the DCR of an SPAD device without substantially reducing its sensitivity.

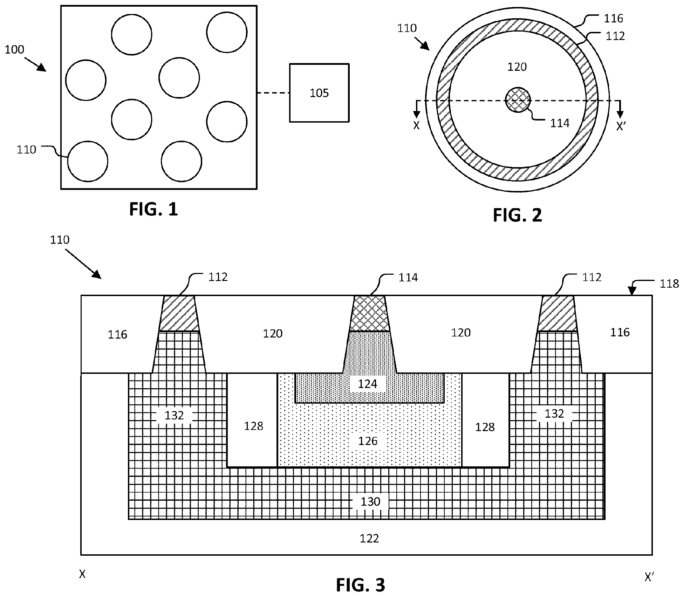

FIG. 1 illustrates a simplified diagram of a photodetector 100 according to an embodiment. The photodetector 100 in FIG. 1 includes a photodiode or SPAD device 110 that detects photons and generates a current indicative of the detected photons.

While the simplified diagram of FIG. 1 only shows a few circular SPADs 110, the number of SPADs 110 in a photodetector can vary by several orders of magnitude depending on the application. The shape of an SPAD 110 is not limited to being circular and can be oval, square or another rectilinear shape such as octagonal, for example.

The photodetector 100 in FIG. 1 may comprise a control circuit 105 configured to control operations of the SPAD 110. The control circuit 105 is electrically coupled to the SPAD 110 and may be configured to apply a bias voltage to the SPAD 110 for detection of a photon, sense an avalanche current generated from the SPAD 110, quench avalanche current by adjusting the bias voltage, and restore the bias voltage to an operating level for detection of another photon.

FIG. 2 illustrates an incident surface of an SPAD 110 that may be in a photodetector 100. The incident surface may be a surface of the SPAD 110 at which light that enters active structures of the SPAD. Additional structures such as a lens, a coating, or electrodes (not shown) may be present on the incident surface.

The SPAD 110 includes an inner highly doped pickup region which is referred to as central source/drain (S/D) 114 and an outer S/D 112 that are separated by an inner STI structure 120. Each of the S/Ds may be an anode or a cathode of the SPAD 110. As used herein to describe various structures, "central" is a general descriptor of a region and not a specific geometric limitation. An outer STI structure 116 is present around the outer rim of the SPAD 110. In the embodiment of FIG. 2, the inner STI structure 120 covers a substantial portion of the incident surface of the SPAD 110.

FIG. 3 illustrates a simplified cross-sectional view of an SPAD 110 taken along the X-X' plane of FIG. 2. The SPAD 110 is formed in a semiconductor substrate 122. The substrate 122, or at least the portion of the substrate 122 in which the SPAD 110 is located, may be lightly doped with dopants of a first type. The first dopant type may be the same dopant type as the central S/D 114. For example, when the first dopant type is P type, the substrate 122 may have a P- doping and the central S/D 114 may have a P+ doping.

The central S/D 114 is electrically coupled to a central well 124 and a central deep well 126. The central S/D 114, central well 124 and central deep well 126 may all be doped with the same dopant type, e.g. the first dopant type. The central S/D 114 may have a high dopant level on the order of 10¹⁹/cm³, and the central well 124 and central deep well may have dopant concentrations of on the order of 10¹⁷/cm³. The semiconductor substrate 122, including intrinsic regions around the central deep well 126, may have a lower dopant concentration on the order of 10¹⁵/cm³. These concentrations are merely examples.

The outer S/D 112 is electrically coupled to an outer well 132 and a lower deep well 130. The lower deep well 130 may extend under the central deep well 124 and be adjacent to the central deep well 124 to form a multiplication region at the interface between the lower deep well 130 and the central deep well 126. The outer well 132 extends between and electrically couples the outer S/D 112 and the lower deep well 130. The dopant concentration of the lower deep well 130 and the outer well 132 may be on the order of 10¹⁷/cm³, and the dopant concentration of outer the S/D 112 may be on the order of 10¹⁹/cm³, for example.

As noted above, an intrinsic region 128 of the semiconductor substrate 122 is located between the outer well 132 and the central wells 124 and 126. The intrinsic region 128 may be bounded in the vertical plane by the lower deep well 130 and a lower surface of the inner STI 120.

An inner STI 120 and an outer STI 116 are located at the top of the SPAD 110. The upper surface of the inner STI 120 and an outer STI 116 may be coplanar with upper surfaces of the outer S/D 112 and the central S/D 114, and the upper surfaces of these structures form a portion of the incident surface 118. The inner and outer STIs 120 and 116 may be an insulating material such as an oxide of silicon, for example.

In an embodiment, the inner STI 120 overlaps at least a portion of the central well 124 and a portion of the central deep well 126. In some embodiments, the inner STI 120 may have a height that extends along at least half of a height of the central well 124, so that sidewalls of the inner STI 120 overlap with more than half of the central well 124 in the vertical dimension. A lower surface of the inner STI 120 may be located above a lower surface of the central well 124 such that the interface between the lower surface of central well 124 and the central deep well 126 is not reduced by the inner STI 120. In the resulting structure, an upper portion of the central well 124 has a first width, and a lower portion of the central well 124 has a second width that is greater than the first width. In such an embodiment, the central well 124 may be characterized as having a shoulder around its upper edge.

As seen in FIG. 3, the inner STI 120 may also overlap with an inner side portion of the outer well 132. In another embodiment, the inner STI 120 may be directly adjacent to the outer well 132 without any overlap. Accordingly, the inner STI 120 may cover the entire width of the intrinsic region 128.

The outer STI 116 may overlap with an outer side portion of the outer well 132. The overlap of inner STI 120 and outer STI 116 on opposite sides of the outer well 132 may result in a structure in which an upper portion of the outer well 132 has a first width, and a lower portion of the outer well 132 has a second width that is greater than the first width. In such an embodiment, the outer well 132 may be characterized as having two shoulders respectively around an inner and outer edge of an upper part of the central well 124.

Outer edges of the outer STI 116 may be located outside of an outer perimeter of outer S/D 112 as seen in FIG. 2. However, embodiments are not limited to this configuration. In some embodiments, the outer STI 116 may cover the area between two adjacent SPADs 110, such that the spaces between SPADS 110 in an SPAD region of a device are occupied by STI structures at the incident surface 118.

In another embodiment, adjacent SPADs 110 may share outer wells 132. For example, SPADS 110 may have a square shape in which multiple SPADs 110 in an array share lower deep wells 130, outer wells 132, and outer S/Ds 112 and have respective individual central S/Ds 114, central wells 124 and central deep wells 126. In such an embodiment, no outer STIs 116 may be present between adjacent SPADs 110. Instead, the outer S/D 112 may be bounded by two inner STIs 120. In such an embodiment, as well as the embodiment shown in FIG. 3, the outer S/D 112 is bounded on either side by STIs at incident surface 118.

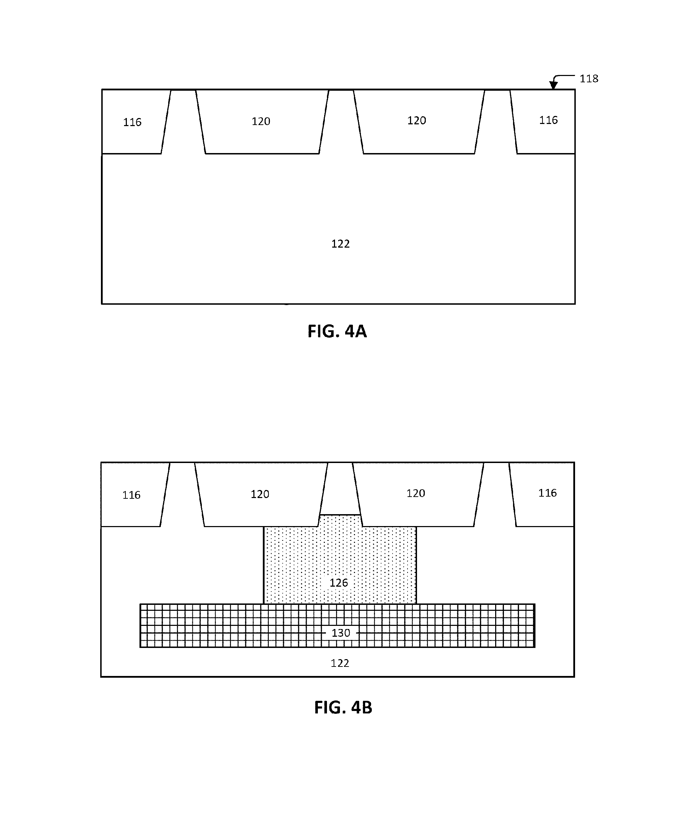

FIGS. 4A to 4D illustrate an example of stages in a process for forming an SPAD 110 according to an embodiment of the present disclosure.

As seen in FIG. 4A, STI structures are formed at an incident surface 118 of a semiconductor substrate 122. Forming the STI structures may comprise forming openings in an exposed surface of the semiconductor substrate 122 using a mask and etch process as known in the art, depositing an insulating material such as a silicon oxide in the openings, and performing a planarization process (e.g., a chemical mechanical polishing (CMP) process) to remove residual materials from the incident surface 118. Additional materials such as liner materials (not shown) may be deposited inside the openings before depositing the primary insulating material, e.g. silicon oxide.

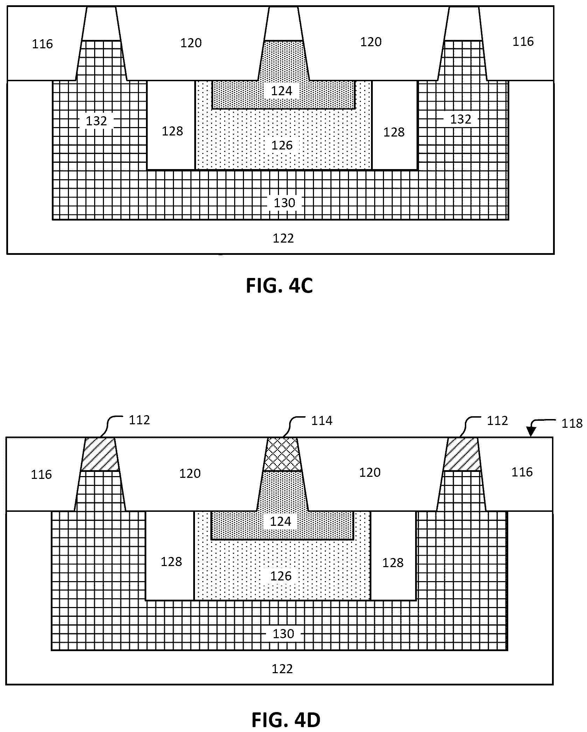

Lower deep well 130 is formed by implanting dopants of a second type (N or P) into the substrate, and central deep well 126 is formed by implanting dopants of a first type (opposite to the first type) into the substrate as seen in FIG. 4B. Next, as seen in FIG. 4C, two additional dopant implant steps are performed to form outer wells 132 and central well 124. Dopants of the central well 124 are the same type of dopants as the central deep well 126, and dopants of the lower deep well 130 are the same type of dopants as the outer well 132.

As seen in FIG. 4D, dopants are implanted to form outer S/D 112 and central S/D 114. The concentration of dopants of the outer S/D 112 and central S/D 114 may be higher than the underlying structures. For example, while the wells may have N and P doping, the S/Ds may have N+ and P+ doping. Additional structures (not shown) may be formed on incident surface 118 such as an anti-reflective coating, a lens, electrodes, a sealing layer, a protective layer, etc.

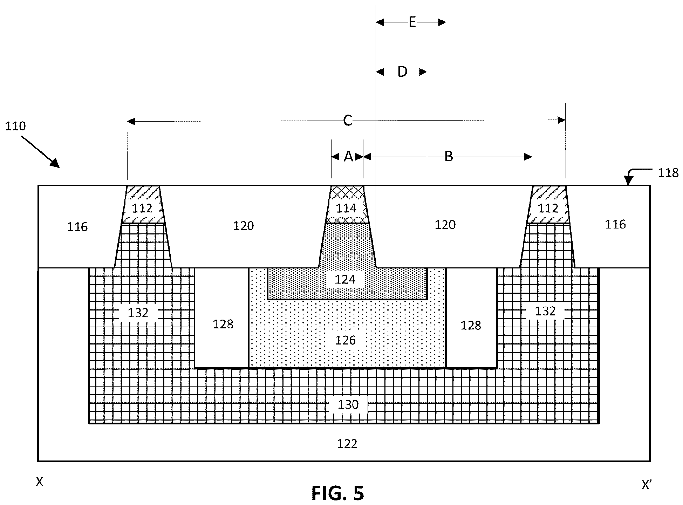

The size of STI 120 may be characterized relative to the size of the central or inner S/D 114. For example, in some embodiments, a ratio of the width of the central S/D 114 (width "A" in FIG. 5) to the width of the inner STI 120 (width "B" in FIG. 5) may be from about 1:25 to 1:0.33. That is, the width (e.g., distance from inner to outer diameter in a circular device or line width in a rectilinear device) of the inner STI 120 may be from about twenty-five times to one third the width of central S/D 114.

In various embodiments, the width of the STI 120 adjacent to the central S/D 114 may be one third, one half, three quarters, the same, two times, five times, 10 times, 20 times, 25 times, or greater than the width of central S/D 114 at the incident surface 118 of an SPAD 110. The inventors have found that SPADs within these ratios provide reduced dark current rate compared to conventional devices while maintaining good sensitivity. The size of the central S/D may be at least 0.1 microns in diameter to provide sufficient contact area for an electrode and volume for charge, and as a practical matter this size may limit the maximum possible ratio between the STI 120 and the central S/D 114. In some examples, the ratio of the width of the STI 120 and the central S/D 114 may be within a range of from 1:3 to 30:1, from 1:2 to 25:1, or from 1:1 to 20:1.

Embodiments of the present disclosure may also be characterized by the amount of surface area of the SPAD 110 occupied by an STI. The surface area of the SPAD 110 may be the area within the outer edges of outer S/D 112, which is shown as dimension "C" in FIG. 5. In this case, outer STI 116 is not within the surface area of the SPAD 110. In various embodiments, the inner STI 120 may occupy 33%, 40%, 50%, 60%, 70%, 80%, 90% or more of the surface area of the incident surface 118 of an SPAD 110.

As seen in FIG. 5, the inner STI 120 overlaps with a portion of the central well 124 and a portion of the central deep well 126 in the horizontal dimension as indicated by overlap distances "D" and "E" respectively. The amount of overlap here may be expressed in terms of a total width of the wells 124 and 126. So, for example, if the total width of the central well 124 is 100 units, and the size of dimension D is 5 units, the amount of overlap between the inner STI 120 and the central well 124 is 10% (5+5) = 10% of 100). In various embodiments, the inner STI 120 may overlap at least 10%, 20%, 50%, 75%, 90% or more of a width of the central well 124 (dimension "D" in FIG. 5). In various embodiments, the inner STI 120 may overlap at least 15%, 20%, 50%, 75%, 90% or more of a width of the central deep well 126 (dimension "E" in FIG. 5).

The sizes of the well and STI structures may vary between embodiments and may generally be on the micron scale. For example, the width of central S/D 114 may vary between about 0.25 to 10 microns, and the width of inner STI 120 may be around 2 to 8 microns. However, the sizes may differ depending on the application, and embodiments are not limited to values within these exemplary ranges.

Embodiments of the present disclosure represent improvements to SPAD technology. An inner STI 120 with a relatively large width compared to a width of a central S/D 114 at an incident surface 118 of an SPAD 110 can reduce the dark current rate with minimal expense and processing complexity. Without being bound by theory, possible explanations for these benefits may include the reduction of a surface e-field, suppression of defects in the implant loop, and mitigation of surface contamination.

Aspects of the present disclosure have been described in conjunction with the specific embodiments thereof that are proposed as examples. Numerous alternatives, modifications, and variations to the embodiments as set forth herein may be made without departing from the scope of the claims set forth below. Accordingly, embodiments as set forth herein are intended to be illustrative and not limiting.

In summary, a single photon avalanche diode (SPAD) device including a semiconductor substrate, a central source/drain, an outer source/drain, and a shallow trench isolation (STI) structure between the central source/drain and the outer source/drain at an incident surface of the substrate is disclosed. A width of the STI structure is at least one third of a width of the central source/drain. The SPAD device may have superior dark current rate compared to conventional devices.
The following embodiments are explicitly disclosed.

### Embodiment 1:

A single photon avalanche diode (SPAD) device, comprising:
a semiconductor substrate;
a central source/drain;
an outer source/drain; and
a shallow trench isolation (STI) structure between the central source/drain and the outer source/drain at an incident surface of the substrate,
wherein a width of the STI structure is at least one third of a width of the central source/drain.

In some illustrative examples of embodiment 1, the SPAD device may further comprise a central deep well under the central well, and a lower deep well under the outer well, wherein the lower deep well extends under the central deep well, and wherein a multiplication region is located at an interface between the central deep well and the lower deep well. For example, the central source/drain, central well and central deep well may be doped with a first type of dopants, and the outer source/drain, outer well and lower deep well may be doped with a second type of dopants.

### Embodiment 2:

The SPAD device of embodiment 1, wherein the width of the STI structure is at least half the width of the central source/drain.

### Embodiment 3:

The SPAD device of embodiment 1, wherein the width of the STI structure is the same or greater than the width of the central source/drain.

### Embodiment 4:

The SPAD device of one of embodiments 1 to 3, wherein the STI structure occupies at least 40% of the surface area of the incident surface of the SPAD device.

### Embodiment 5:

The SPAD device of one of embodiments 1 to 4, wherein the STI structure occupies at least 70% of the surface area of the incident surface of the SPAD device.

### Embodiment 6:

The SPAD device of one of embodiments 1 to 5, further comprising a central doped well under the central source/drain, wherein the STI structure overlaps at least 10% of a width of the doped well.

### Embodiment 7:

The SPAD device of embodiment 6, further comprising a central deep well under the central well and coupled to the central well, wherein the STI structure overlaps at least 15% of a width of the central deep well.

In some illustrative embodiments herein, the central source/drain, central well and central deep well may be doped with a first type of dopants, and the outer source/drain may be doped with a second type of dopants.

### Embodiment 8:

The SPAD device of one of embodiments 1 to 5, further comprising:
a central well under the central source/drain;
a central deep well under the central well;
an outer well under the outer source/drain; and
a lower deep well under the outer well, wherein the lower deep well extends under the central deep well, and a multiplication region is located at an interface between the central deep well and the lower deep well.

### Embodiment 9:

The SPAD device of embodiment 8, wherein the central source/drain, central well and central deep well are doped with a first type of dopants, and the outer source/drain, outer well and lower deep well are doped with a second type of dopants.

### Embodiment 10:

The SPAD device of one of embodiments 1 to 9, wherein the width of the STI structure is 30 times the width of the central source/drain or less.

### Embodiment 11:

A photodetector comprising a control circuit and at least one single photon avalanche diode (SPAD) coupled to the control circuit, the at least one SPAD comprising:
a semiconductor substrate;
a central source/drain;
an outer source/drain; and
a shallow trench isolation (STI) structure between the central source/drain and the outer source/drain at an incident surface of the substrate,
wherein a width of the STI structure is at least one third of a width of the central source/drain.
In some illustrative examples herein, the photodetector of embodiment 11 may be based on the SPAD device on at least one of embodiments 1 to 10 above in that each of the at least one SPAD of the photodetector may formed or provided in accordance with the SPAD device of one of embodiments 1 to 10 above.

### Embodiment 12:

The photodetector of embodiment 11, wherein the width of the STI structure is at least half the width of the central source/drain.

### Embodiment 13:

The photodetector of embodiment 11, wherein the width of the STI structure is the same or greater than the width of the central source/drain.

### Embodiment 14:

The photodetector of one of embodiments 11 to 13, wherein the STI structure occupies at least 40% of the surface area of the incident surface of the SPAD device.

### Embodiment 15:

The photodetector of one of embodiments 11 to14, wherein the STI structure occupies at least 70% of the surface area of the incident surface of the SPAD device.

### Embodiment 16:

The photodetector of one of embodiments 11 to 15, further comprising a central doped well under the central source/drain, wherein the STI structure overlaps at least 10% of a width of the doped well.

### Embodiment 17:

The photodetector of embodiment 16, further comprising a central deep well under the central well and coupled to the central well, wherein the STI structure overlaps at least 15% of a width of the central deep well.

### Embodiment 18:

The photodetector of one of embodiments 11 to 17, further comprising:
a central well under the central source/drain;
a central deep well under the central well;
an outer well under the outer source/drain; and
a lower deep well under the outer well, wherein the lower deep well extends under the central deep well, and a multiplication region is located at an interface between the central deep well and the lower deep well.

### Embodiment 19:

The photodetector of one of embodiments 11 to 18, wherein the width of the STI structure is 30 times the width of the central source/drain or less.

### Embodiment 20:

A method for forming an SPAD device, the method comprising:
forming a shallow trench isolation (STI) structure in a semiconductor sub strate;
forming a central source/drain in an opening of the STI structure; and
forming an outer source/drain around the STI structure;
wherein the STI structure is between the central source/drain and the outer source/drain at an incident surface of the substrate, and a width of the STI structure is at least one third of a width of the central source/drain.

### Embodiment 21:

The method of embodiment 20, wherein the SPAD device of one of embodiments 1 to 10 is formed.

### Embodiment 22:

The method of embodiment 20 or 21, further comprising
providing a control circuit;
electrically coupling the control circuit with the single photon avalanche diode device; and
controlling operation of the single photon avalanche diode device by the control circuit.

### Embodiment 23:

A method for operating a photodetector comprising a control circuit and at least one single photon avalanche diode device coupled to the control circuit, the method comprising:
applying a bias voltage to the single photon avalanche diode device for detection of a photon,
sensing an avalanche current generated from the single photon avalanche diode device, and a quench avalanche current by adjusting the bias voltage, and
restoring the bias voltage to an operating level for detection of another photon.

### Embodiment 24:

The method of embodiment 23, wherein the method is provided for operating the photodetector of one of embodiments 11 to 19.

## Claims

1. A single photon avalanche diode device, comprising:
a semiconductor substrate;
a central source/drain;
an outer source/drain; and
a shallow trench isolation (STI) structure between the central source/drain and the outer source/drain at an incident surface of the substrate,
wherein a width of the STI structure is at least one third of a width of the central source/drain.

2. The single photon avalanche diode device of claim 1, wherein the width of the STI structure is at least half the width of the central source/drain.

3. The single photon avalanche diode device of claim 1, wherein the width of the STI structure is the same or greater than the width of the central source/drain.

4. The single photon avalanche diode device of one of claims 1 to 3, wherein the STI structure occupies at least 40% of the surface area of the incident surface of the single photon avalanche diode device.

5. The single photon avalanche diode device of one of claims 1 to 4, wherein the STI structure occupies at least 70% of the surface area of the incident surface of the single photon avalanche diode device.

6. The single photon avalanche diode device of one of claims 1 to 5, further comprising a central doped well under the central source/drain, wherein the STI structure overlaps at least 10% of a width of the doped well.

7. The single photon avalanche diode device of claim 6, further comprising a central deep well under the central well and coupled to the central well, wherein the STI structure overlaps at least 15% of a width of the central deep well.

8. The single photon avalanche diode device of one of claims 1 to 5, further comprising:
a central well under the central source/drain;
a central deep well under the central well;
an outer well under the outer source/drain; and
a lower deep well under the outer well, wherein the lower deep well extends under the central deep well, and a multiplication region is located at an interface between the central deep well and the lower deep well.

9. The single photon avalanche diode device of claim 8, wherein the central source/drain, central well and central deep well are doped with a first type of dopants, and the outer source/drain, outer well and lower deep well are doped with a second type of dopants.

10. The single photon avalanche diode device of one of claims 1 to 9, wherein the width of the STI structure is 30 times the width of the central source/drain or less.

11. A photodetector comprising a control circuit and at least one single photon avalanche diode device coupled to the control circuit, each of the at least one single photon avalanche diode device being provided in accordance with the single photon avalanche diode device of one of claims 1 to 10.

12. A method for forming a single photon avalanche diode device, the method comprising:
forming a shallow trench isolation (STI) structure in a semiconductor sub strate;
forming a central source/drain in an opening of the STI structure; and
forming an outer source/drain around the STI structure;
wherein the STI structure is between the central source/drain and the outer source/drain at an incident surface of the substrate, and a width of the STI structure is at least one third of a width of the central source/drain.

13. The method of claim 12, further comprising
providing a control circuit;
electrically coupling the control circuit with the single photon avalanche diode device; and
controlling operation of the single photon avalanche diode device by the control circuit.

14. The method of claim 12 or 13, wherein the single photon avalanche diode device of one of claims 1 to 10 is formed.

15. A method for operating a photodetector comprising a control circuit and at least one single photon avalanche diode device coupled to the control circuit, preferably a method for operating the photodetector of claim 11, the method comprising:
applying a bias voltage to the single photon avalanche diode device for detection of a photon,
sensing an avalanche current generated from the single photon avalanche diode device, and a quench avalanche current by adjusting the bias voltage, and
restoring the bias voltage to an operating level for detection of another photon.
